# EUROPEAN PATENT SPECIFICATION

(11) **EP 2 867 951 B1**
(45) Date of publication and mention of the grant of the patent: **30.08.2017**
(21) Application number: 13818778.6
(22) Date of filing: 22.10.2013
(51) Int. Cl.: H01M 10/34, H01M 10/48, H01M 10/44

(54) **BATTERY SYSTEM**
BATTERIESYSTEM
SYSTÈME DE BATTERIE

(30) Priority: 25.10.2012 JP 2012235985
(43) Date of publication of application: 06.05.2015
(73) Proprietor: TOYOTA JIDOSHA KABUSHIKI KAISHA, Toyota-shi, Aichi-ken, 471-8571 (JP)
(72) Inventor: KAGAMI, Masahiro, Toyota-shi Aichi-ken 471-8571 (JP)
(74) Representative: Intès, Didier Gérard André
(86) International application number: PCT/IB2013/002361
(87) International publication number: WO 2014/064507

(56) References cited:
- WO-A1-2012/091077
- JP-A- 2004 191 150
- US-A1- 2004 191 619
- US-A1- 2008 125 987
- US-A1- 2012 232 736

## Description

### BACKGROUND OF THE INVENTION

### 1. Field of the Invention

The invention relates to a battery system that limits input and output of a nickel metal hydride battery on the basis of a negative electrode reserve capacity in the nickel metal hydride battery.

### 2. Description of Related Art

In Japanese Patent Application Publication No. 2011-010465 (JP 2011-010465 A), the degree of degradation of a battery on the basis of a distribution of a past temperature history of the battery and an actual rate of increase in work load of the battery against the temperature of the battery. Here, the service life of the battery is extended by limiting the output of the battery where necessary.

In JP 2011-010465 A, the distribution of the temperature history of the battery is created by detecting the temperature of the battery in one drive cycle. Here, degradation of the battery is influenced by not only the temperature of the battery at the time when a vehicle is traveling but also the temperature of the battery at the time when the vehicle is left standing. Particularly, as the temperature of the battery at the time when the vehicle is left standing increases, the battery more easily degrades.

If degradation of the battery is determined on the basis of only the temperature of the battery at the time when the vehicle is traveling, an actual degree of degradation of the battery becomes higher than the determined degree of degradation of the battery, so it is not possible to extend the service life of the battery to a target value.

A further method of detecting and mitigation battery degradation levels is disclosed in US 2013/0271148 A1. The method detects the battery degradation levels from the root-mean-square of the charging and discharging current flow in the battery. Additional temperature readings are taken during and between periods of charging and discharging.

### SUMMARY OF THE INVENTION

A first aspect of the invention relates to a battery system that controls charging and discharging operations of a nickel metal hydride battery. The battery system includes a temperature sensor and a controller. The temperature sensor is configured to detect a temperature of the nickel metal hydride battery and output the detected temperature to the controller. The controller is configured to limit the charging and discharging operations of the nickel metal hydride battery when a negative electrode reserve capacity of the nickel metal hydride battery is smaller than a target value.

The controller is configured to acquire the temperature of the nickel metal hydride battery at the time when the nickel metal hydride battery is being charged or discharged and the temperature of the nickel metal hydride battery at the time when the nickel metal hydride battery is not being charged or discharged with the use of the temperature sensor. The controller is configured to calculate the negative electrode reserve capacities corresponding to the acquired temperatures (the temperature at the time when the nickel metal hydride battery is being charged or discharged and the temperature at the time when the nickel metal hydride battery is not being charged or discharged) using a correspondence relationship between the temperature of the nickel metal hydride battery and the negative electrode reserve capacity.

If the negative electrode reserve capacity of the nickel metal hydride battery is acquired, it is possible to acquire the degradation state of the nickel metal hydride battery. That is, the negative electrode reserve capacity has correlation with a discharging capacity of the nickel metal hydride battery, and, if the discharging capacity of the nickel metal hydride battery decreases due to degradation of the nickel metal hydride battery, the negative electrode reserve capacity decreases. Therefore, when the negative electrode reserve capacity becomes lower than the target value, it is possible to suppress an advance of degradation of the nickel metal hydride battery by limiting the charging and discharging operations of the nickel metal hydride battery. In addition, it is possible to allow the negative electrode reserve capacity to change along the target value.

The negative electrode reserve capacity depends on the temperature of the nickel metal hydride battery, so, if the correspondence relationship between the negative electrode reserve capacity and the temperature is obtained in advance, it is possible to calculate the negative electrode reserve capacity corresponding to the temperature of the nickel metal hydride battery. Here, in the invention, the negative electrode reserve capacity is calculated (estimated) in consideration of not only the temperature of the nickel metal hydride battery at the time when the nickel metal hydride battery is being charged or discharged but also the temperature of the nickel metal hydride battery at the time when the nickel metal hydride battery is not being charged or discharged. Thus, in comparison with the case where the negative electrode reserve capacity is calculated (estimated) on the basis of only the temperature of the nickel metal hydride battery at the time when the nickel metal hydride battery is being charged or discharged, it is possible to improve the accuracy of estimating the negative electrode reserve capacity.

The negative electrode reserve capacity may be calculated by adding an amount of increase in the negative electrode reserve capacity and an amount of reduction in the negative electrode reserve capacity. The negative electrode reserve capacity increases with corrosion of a negative electrode, so the corrosion of the negative electrode may be defined as the amount of increase in the negative electrode reserve capacity. In addition, the negative electrode reserve capacity reduces with emission of hydrogen to an outside of the nickel metal hydride battery, so the emission of hydrogen to the outside of the nickel metal hydride battery may be defined as the amount of reduction in the negative electrode reserve capacity.

The amount of increase in the negative electrode reserve capacity depends on the temperature of the nickel metal hydride battery, so, if the correspondence relationship between the amount of increase and the temperature is obtained in advance, it is possible to determine the amount of increase corresponding to the temperature of the nickel metal hydride battery. In addition, the amount of reduction in the negative electrode reserve capacity depends on the temperature of the nickel metal hydride battery, so, if the correspondence relationship between the amount of reduction and the temperature is obtained in advance, it is possible to determine the amount of reduction corresponding to the temperature of the nickel metal hydride battery. When the amount of increase and the amount of reduction are determined, not only the temperature of the nickel metal hydride battery at the time when the nickel metal hydride battery is being charged or discharged but also the temperature of the nickel metal hydride battery at the time when the nickel metal hydride battery is not being charged or discharged is taken into consideration as described above.

An interval at which the negative electrode reserve capacity is calculated at the time when the charging and discharging operations of the nickel metal hydride battery are limited may be reduced as compared to an interval at which the negative electrode reserve capacity is calculated at the time when the charging and discharging operations of the nickel metal hydride battery are not limited. The negative electrode reserve capacity is smaller than the target value when the charging and discharging operations of the nickel metal hydride battery are limited, so it becomes easy to acquire a variation in the negative electrode reserve capacity and the correlation between the negative electrode reserve capacity and the target value by reducing the interval at which the negative electrode reserve capacity is calculated.

If the charging and discharging operations of the nickel metal hydride battery are limited, it is possible to suppress an increase in the temperature of the nickel metal hydride battery as a result of energization, and it is possible to suppress a reduction in the negative electrode reserve capacity. Accordingly, it is possible to increase the negative electrode reserve capacity as compared to the target value. Here, when the negative electrode reserve capacity becomes larger than the target value, the limitation on the charging and discharging operations may be cancelled. With this configuration, it is possible to efficiently charge or discharge the nickel metal hydride battery.

The nickel metal hydride battery may be mounted on a vehicle. In this case, for example, a battery pack is formed by electrically serially connecting a plurality of single cells (nickel metal hydride batteries), and the battery pack may be mounted on the vehicle. Here, if electric energy output from the nickel metal hydride battery is converted to kinetic energy, it is possible to propel the vehicle using the kinetic energy.

In the configuration that the nickel metal hydride battery is mounted on the vehicle, the controller may be configured to select one of a travel distance and an elapsed time, which defines a service life of the nickel metal hydride battery, on the basis of a usage state of the vehicle. Specifically, in the usage state where the vehicle is frequently caused to travel, the service life of the nickel metal hydride battery tends to depend on the travel distance, so the travel distance may be selected. In addition, in the usage state where the vehicle is not frequency caused to travel, the service life of the nickel metal hydride battery tends to depend on the elapsed time, so the elapsed time may be selected.

The target value may be set such that, when the travel distance is selected, the negative electrode reserve capacity does not reach the negative electrode reserve capacity corresponding to the service life of the nickel metal hydride battery until the travel distance reaches a target travel distance. For example, the target value based on the travel distance may be set such that the negative electrode reserve capacity reaches the negative electrode reserve capacity corresponding to the service life when the travel distance has reached the target travel distance.

More specifically, as the travel distance extends, the target value (negative electrode reserve capacity) may be decreased toward the negative electrode reserve capacity corresponding to the service life. Here, if the negative electrode reserve capacity is changed along the target value, it is possible to continuously use the nickel metal hydride battery until the target travel distance.

The target value may be set such that, when the elapsed time is selected, the negative electrode reserve capacity does not reach the negative electrode reserve capacity corresponding to the service life of the nickel metal hydride battery until the elapsed time reaches a target elapsed time. For example, the target value based on the elapsed time may be set such that the negative electrode reserve capacity reaches the negative electrode reserve capacity corresponding to the service life when the elapsed time has reached the target elapsed time.

More specifically, as the elapsed time extends, the target value (negative electrode reserve capacity) may be decreased toward the negative electrode reserve capacity corresponding to the service life. Here, if the negative electrode reserve capacity is changed along the target value, it is possible to continuously use the nickel metal hydride battery until the target elapsed time.

The negative electrode reserve capacity may be compared with the target value each time one of the travel distance of the vehicle and the elapsed time reaches a corresponding threshold. Here, the threshold is set for each of the travel distance and the elapsed time. Thus, it is possible to acquire the correlation between the negative electrode reserve capacity and the target value on the basis of a variation in the travel distance or the elapsed time.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a view that shows the configuration of a battery system;
FIG. 2 is a flowchart that shows a process of limiting input and output of a battery pack on the basis of a negative electrode reserve capacity;
FIG. 3 is a flowchart that shows a process of determining timing at which the negative electrode reserve capacity is determined;
FIG. 4 is a flowchart that shows a process of estimating the negative electrode reserve capacity;
FIG. 5 is a graph that shows the correlation between the amount of increase in the negative electrode reserve capacity as a result of corrosion of a negative electrode and the temperature of the battery pack;
FIG. 6 is a graph that shows the correlation between the amount of reduction in the negative electrode reserve capacity as a result of permeation of hydrogen through a battery case and the temperature of the battery pack;
FIG. 7 is a graph that shows the correlation between the amount of increase and the amount of reduction in the negative electrode reserve capacity and the negative electrode reserve capacity;
FIG. 8 is a flowchart that shows a process of calculating a target value of the negative electrode reserve capacity;
FIG. 9 is a graph that shows the correlation between a travel distance and an elapsed time in mutually different travel patterns;
FIG. 10 is a graph that shows the correlation between a travel distance and an elapsed time when the travel pattern is changed;
FIG. 11 is a graph that shows a target value of the negative electrode reserve capacity with respect to a total travel distance;
FIG. 12 is a graph that shows a target value of the negative electrode reserve capacity with respect to a total elapsed time; and
FIG. 13 is a graph that shows changes of the negative electrode reserve capacity (estimated value) and changes of the negative electrode reserve capacity (target value).

### DETAILED DESCRIPTION OF EMBODIMENTS

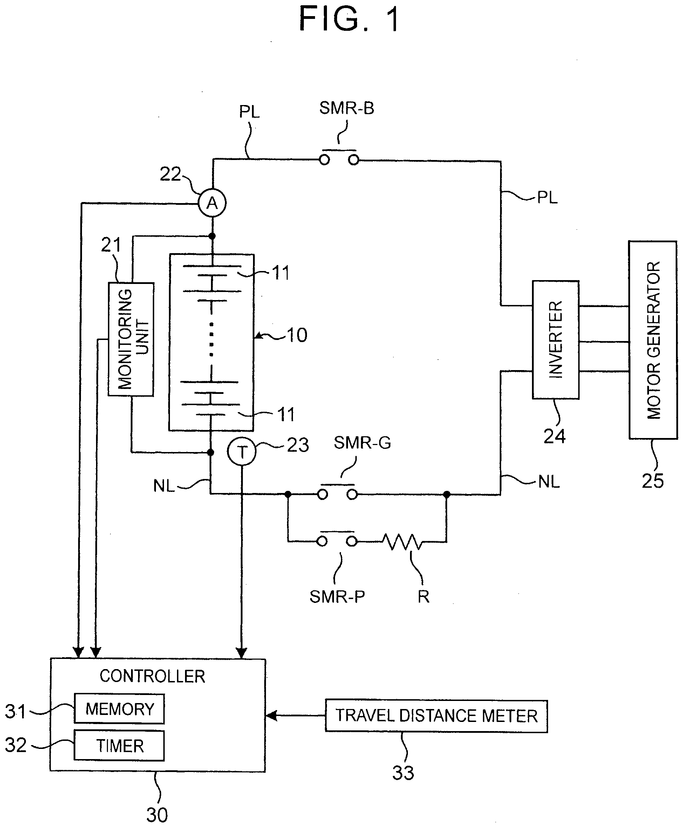

FIG. 1 is a view that shows the configuration of a battery system according to an embodiment. The battery system shown in FIG. 1 is mounted on a vehicle. The vehicle may be a hybrid vehicle or an electric vehicle. The hybrid vehicle includes another power source, such as an engine and a fuel cell, in addition to a battery pack (described later), as a power source for propelling the vehicle. The electric vehicle includes only the battery pack (described later) as a power source for propelling the vehicle.

The battery pack 10 includes a plurality of electrically serially connected single cells 11. Each single cell 11 may be a nickel metal hydride battery. The number of the single cells 11 may be set as needed on the basis of a required output, or the like, of the battery pack 10. In the present embodiment, all the single cells 11 that constitute the battery pack 10 are connected in series with one another; instead, the battery pack 10 may include a plurality of the single cells 11 that are electrically connected in parallel with each other.

Each single cell 11 may be formed by containing a power generating element that carries out charging and discharging operations in a battery case. In addition, a plurality of power generating elements may be contained in the battery case. In this case, the plurality of power generating elements may be electrically connected in series with each other inside the battery case. The battery case may be, for example, formed of a resin.

Each power generating element includes a positive electrode plate, a negative electrode plate and a separator arranged between the positive electrode plate and the negative electrode plate. The positive electrode plate has a current collector and a positive electrode active material layer formed on the surface of the current collector. The negative electrode plate has a current collector and a negative electrode active material layer formed on the surface of the current collector. Here, the positive electrode active material layer, the negative electrode active material layer and the separator contain an electrolytic solution. The positive electrode active material layer includes a positive electrode active material, such as nickel hydroxide, and the negative electrode active material layer includes a hydrogen storage alloy that serves as a negative electrode active material.

A monitoring unit 21 detects the terminal voltage of the battery pack 10, and outputs the detected result to a controller 30. Here, the monitoring unit 21 is able to detect the terminal voltage of each of the single cells 11. In addition, as described above, when a plurality of power generating elements are contained in a battery case, the monitoring unit 21 is able to detect the terminal voltage of the plurality of power generating elements.

A current sensor 22 detects a current flowing through the battery pack 10, and outputs the detected result to the controller 30. Here, when the battery pack 10 is being discharged, a positive value may be used as a current value that is detected by the current sensor 22. When the battery pack 10 is being charged, a negative value may be used as a current value that is detected by the current sensor 22.

In the present embodiment, the current sensor 22 is provided in a positive electrode line PL connected to the positive electrode terminal of the battery pack 10; however, the current sensor 22 just needs to be able to detect a current value flowing through the battery pack 10, and a location at which the current sensor 22 is provided may be set as needed. Alternatively, a plurality of the current sensors 22 may be used. A temperature sensor 23 detects the temperature of the battery pack 10 (single cells 11), and outputs the detected result to the controller 30.

The controller 30 includes a memory 31. The memory 31 stores various pieces of information, which are used when the controller 30 executes a predetermined process (for example, a process described in the present embodiment). The controller 30 has a timer 32. The timer 32 is used to measure a period of time. In the present embodiment, the memory 31 and the timer 32 are incorporated in the controller 30; instead, at least one of the memory 31 and the timer 32 may be provided outside the controller 30. A travel distance meter 33 measures a travel distance from when the vehicle starts to be used to present time, and outputs the measured result to the controller 30.

A system main relay SMR-B is provided in the positive electrode line PL. The system main relay SMR-B switches between an on state and an off state upon reception of a control signal from the controller 30. A system main relay SMR-G is provided in a negative electrode line NL connected to the negative electrode terminal of the battery pack 10. The system main relay SMR-G switches between an on state and an off state upon reception of a control signal from the controller 30.

A system main relay SMR-P and a current limiting resistor R are electrically connected to the system main relay SMR-G. The system main relay SMR-P and the current limiting resistor R are electrically serially connected to each other. The system main relay SMR-P switches between an on state and an off state upon reception of a control signal from the controller 30. The current limiting resistor R is used to suppress flow of inrush current when the battery pack 10 is connected to a load (specifically, an inverter 24 (described later)).

The battery pack 10 is connected to the inverter 24 via the positive electrode line PL and the negative electrode line NL. When the battery pack 10 is connected to the inverter 24, the controller 30 initially switches the system main relay SMR-B from the off state to the on state, and switches the system main relay SMR-P from the off state to the on state. Thus, it is possible to suppress flow of inrush current by flowing current through the current limiting resistor R.

Next, the controller 30 switches the system main relay SMR-G from the off state to the on state, and then switches the system main relay SMR-P from the on state to the off state. Thus, connection of the battery pack 10 with the inverter 24 is completed, and the battery system shown in FIG. 1 enters an activated state (ready-on state). Information about on/off states of an ignition switch of the vehicle is input to the controller 30. The controller 30 starts up the battery system shown in FIG. 1 when the ignition switch is switched from the off state to the on state.

On the other hand, when the ignition switch is switched from the on state to the off state, the controller 30 switches the system main relays SMR-B, SMR-G from the on state to the off state. Thus, connection of the battery pack 10 with the inverter 24 is interrupted, and the battery system enters a stopped state (ready-off state).

The inverter 24 converts direct-current power, output from the battery pack 10, to alternating-current power, and outputs the alternating-current power to a motor generator 25. The motor generator 25 generates kinetic energy for propelling the vehicle upon reception of the alternating-current power output from the inverter 24. The kinetic energy generated by the motor generator 25 is transmitted to a wheel, and is able to propel the vehicle.

When the vehicle is decelerated or the vehicle is stopped, the motor generator 25 converts kinetic energy, generated during braking of the vehicle, to electric energy (alternating-current power). The inverter 24 converts alternating-current power, generated by the motor generator 25, to direct-current power, and outputs the direct-current power to the battery pack 10. Thus, the battery pack 10 is able to store regenerated electric power.

In the present embodiment, the battery pack 10 is connected to the inverter 24; however, the battery pack 10 is not limited to this configuration. Specifically, a step-up circuit may be provided in a current path between the battery pack 10 and the inverter 24. The step-up circuit is able to step up the output voltage of the battery pack 10 and then to output the stepped-up electric power to the inverter 24. In addition, the step-up circuit is able to step down the output voltage of the inverter 24 and then to output the stepped-down electric power to the battery pack 10.

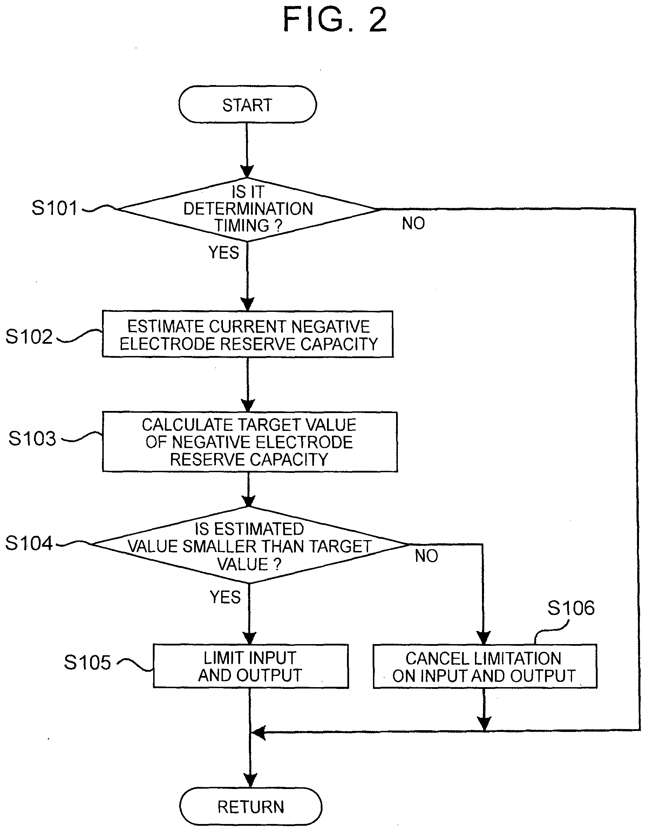

Next, a process of controlling input and output of the battery pack 10 according to the present embodiment will be described with reference to the flowchart shown in FIG. 2. The process shown in FIG. 2 is executed by the controller 30, and is repeatedly executed at predetermined intervals.

In step S101, the controller 30 determines whether it is the timing at which a reserve capacity of the negative electrode is determined. Determination as to the reserve capacity is a process of determining whether degradation of the battery pack 10 has excessively advanced on the basis of the reserve capacity as will be described later. The details of the process of step S101 will be described later.

Generally, in each single cell (nickel metal hydride battery) 11, the capacity of the negative electrode is larger than the capacity of the positive electrode. Thus, the discharge capacity of each single cell 11 is limited by the capacity of the positive electrode, and such limitation is called positive electrode restriction. By subjecting the discharge capacity of each single cell 11 to positive electrode restriction, it is possible to suppress an increase in the internal pressure of each single cell 11 at the time of overcharging and at the time of overdischarging.

By contrasting the negative electrode with the positive electrode, a chargeable excess uncharged portion is termed charging reserve capacity, and a dischargeable excess charged portion is termed discharging reserve capacity. The charging reserve capacity and the discharging reserve capacity have correlation with each other. When the charging reserve capacity or the discharging reserve capacity is increased, it is possible to improve the discharging capacity of the single cell 11. In the present embodiment, it is determined whether degradation of the battery pack 10 has excessively advanced on the basis of the negative electrode reserve capacity (charging reserve capacity or discharging reserve capacity).

When it is the timing at which the negative electrode reserve capacity is determined, the controller 30 executes the process of step S102. On the other hand, when it is not the timing at which the negative electrode reserve capacity is determined, the controller 30 ends the process shown in FIG. 2.

In step S102, the controller 30 estimates the current negative electrode reserve capacity of the battery pack 10. Here, the details of the process of estimating the negative electrode reserve capacity will be described later. In step S103, the controller 30 calculates a target value of the negative electrode reserve capacity. The target value of the negative electrode reserve capacity is a target value for ensuring the service life of the battery pack 10, and is calculated in consideration of a travel distance and an elapsed time as will be described later. The details of the process of calculating the target value of the negative electrode reserve capacity will be described later.

In step S104, the controller 30 determines whether the negative electrode reserve capacity (estimated value) calculated in the process of step S102 is smaller than the negative electrode reserve capacity (target value) calculated in the process of step S103. Here, when the estimated value of the negative electrode reserve capacity is smaller than the target value of the negative electrode reserve capacity, the controller 30 executes the process of step S105. On the other hand, when the estimated value of the negative electrode reserve capacity is larger than the target value of the negative electrode reserve capacity, the controller 30 executes the process of step S106, and ends the process shown in FIG. 2.

When the estimated value of the negative electrode reserve capacity is smaller than the target value of the negative electrode reserve capacity, the controller 30 determines that degradation (decrease in capacity) of the battery pack 10 has advanced beyond the scope of the assumption. On the other hand, when the estimated value of the negative electrode reserve capacity is larger than the target value of the negative electrode reserve capacity, the controller 30 determines that degradation (decrease in capacity) of the battery pack 10 has not advanced beyond the scope of the assumption.

In step S105, the controller 30 decreases an upper limit electric power at which the battery pack 10 is allowed to be input or output (charged or discharged). Here, when the vehicle is caused to travel, the input and output of the battery pack 10 are controlled such that the electric power of the battery pack 10 does not exceed the upper limit electric power. Therefore, by decreasing the upper limit electric power to limit the input and output of the battery pack 10, it is possible to suppress a reduction in the negative electrode reserve capacity.

When the input and output of the battery pack 10 are limited, it is possible to suppress an increase in the temperature of the battery pack 10 as a result of the input and output of the battery pack 10. By suppressing an increase in the temperature of the battery pack 10, it is possible to suppress a reduction in the negative electrode reserve capacity. In this way, by suppressing a reduction in the negative electrode reserve capacity, it is possible to retard an advance of degradation (decrease in capacity) of the battery pack 10, so it is possible to extend the service life of the battery pack 10.

The upper limit electric power is set for each of the input electric power and output electric power of the battery pack 10. The upper limit electric power for each of the input and output of the battery pack 10 may be set as needed. Here, each upper limit electric power may be preset on the basis of the temperature and the state of charge (SOC) of the battery pack 10. Through the process of step S105, each upper limit electric power is decreased below the corresponding preset value. The SOC is the percentage of a current charge capacity with respect to a full charge capacity.

When each upper limit electric power is preset, for example, the upper limit electric power is decreased as the temperature of the battery pack 10 increases or the upper limit electric power is increased as the temperature of the battery pack 10 decreases. In addition, the upper limit electric power (input electric power) is decreased when the SOC of the battery pack 10 is higher than a predetermined upper limit SOC or the upper limit electric power (output electric power) is decreased when the SOC of the battery pack 10 is lower than a predetermined lower limit SOC.

Here, an amount by which each upper limit electric power is decreased may be set to a constant value irrespective of the correlation between the estimated value of the negative electrode reserve capacity and the target value of the negative electrode reserve capacity. However, an amount by which each upper limit electric power is decreased may be varied on the basis of a difference between the estimated value of the negative electrode reserve capacity and the target value of the negative electrode reserve capacity.

Specifically, an amount by which each upper limit electric power is decreased is allowed to be increased as the difference between the estimated value of the negative electrode reserve capacity and the target value of the negative electrode reserve capacity increases. In other words, the input and output of the battery pack 10 are allowed to be further limited as the difference between the estimated value of the negative electrode reserve capacity and the target value of the negative electrode reserve capacity increases. In this way, by varying an amount, by which each upper limit electric power is decreased, on the basis of the difference between the estimated value of the negative electrode reserve capacity and the target value of the negative electrode reserve capacity, a decrease in the estimated value of the negative electrode reserve capacity is more easily suppressed, so it is possible to quickly bring the estimated value of the negative electrode reserve capacity close to the target value of the negative electrode reserve capacity.

In step S106, the controller 30 cancels the process of limiting the input and output of the battery pack 10. Specifically, when the estimated value of the negative electrode reserve capacity becomes larger than the target value of the negative electrode reserve capacity through the process of step S105, the controller 30 cancels the limitation on the input and output of the battery pack 10. Thus, the upper limit electric power returns to the value before the input and output of the battery pack 10 are limited through the process of step S105. When the input and output of the battery pack 10 are not limited, limitation on the input and output of the battery pack 10 is not cancelled and the preset upper limit electric powers are used in the process of step S106.

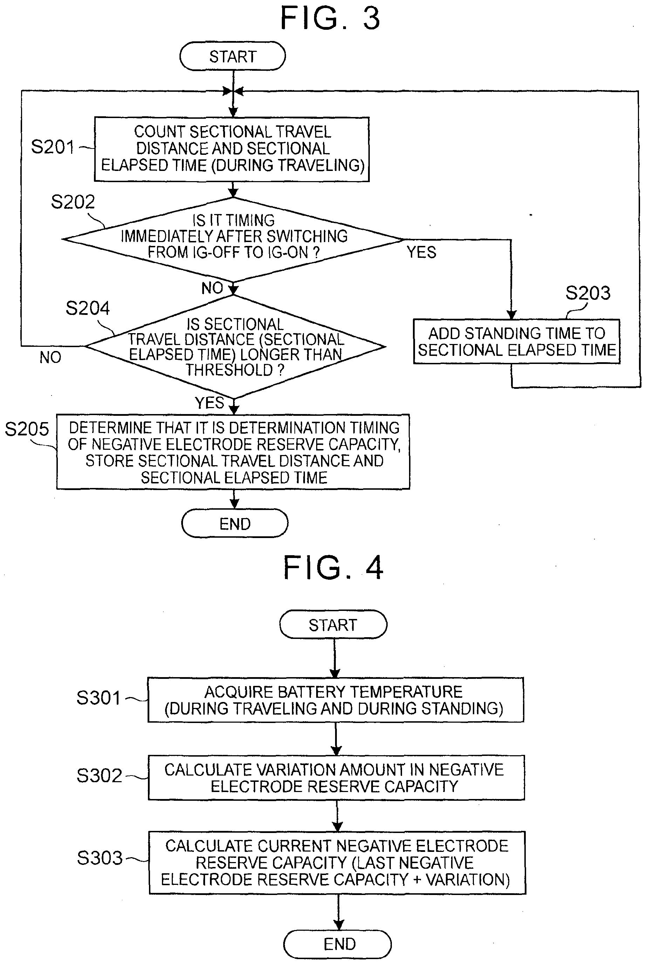

Next, the details of the process of step S101 shown in FIG. 2 will be described with reference to the flowchart shown in FIG. 3. The process shown in FIG. 3 is executed by the controller 30.

In step S201, the controller 30 counts a sectional travel distance on the basis of an output from the travel distance meter 33 and counts a sectional elapsed time with the use of the timer 32. Here, the sectional travel distance is a travel distance from when the negative electrode reserve capacity has been determined last time to present time. In addition, the sectional elapsed time is an elapsed time from when the negative electrode reserve capacity has been determined last time to present time, and is an elapsed time when the vehicle is traveling, in other words, when the ignition switch is on.

In step S202, the controller 30 determines whether it is the timing immediately after the ignition switch is switched from the off state to the on state. When it is the timing immediately after the ignition switch is switched from the off state to the on state, the controller 30 executes the process of step S203. On the other hand, when a certain period of time has elapsed from when the ignition switch is switched from the off state to the on state, the controller 30 executes the process of step S204. Here, determination as to whether it is the timing immediately after the ignition switch is switched from the off state to the on state just needs to be made by determining whether a predetermined period of time has elapsed after the ignition switch is switched from the off state to the on state.

In step S203, the controller 30 adds a period of time during which the vehicle is left standing (standing time) to the sectional elapsed time that is used in the process of step S201. The period of time during which the vehicle is left standing is a period of time during which the ignition switch is in the off state, and this period of time can be measured with the use of the timer 32. When the ignition switch is switched from the off state to the on state, a period of time including the standing time is used as the sectional elapsed time.

In step S204, the controller 30 determines whether the sectional travel distance counted in the process of step S201 is longer than a threshold (travel distance). The threshold (travel distance) is a value that defines the timing at which the negative electrode reserve capacity is determined. That is, each time the sectional travel distance reaches the threshold (travel distance), the negative electrode reserve capacity is determined.

The controller 30 determines in step S204 whether the sectional elapsed time counted in the process of step S201 is longer than a threshold (elapsed time). The threshold (elapsed time) is a value that defines the timing at which the negative electrode reserve capacity is determined. That is, each time the sectional elapsed time reaches the threshold (elapsed time), the negative electrode reserve capacity is determined.

The controller 30 executes the process of step S205 when one of the sectional travel distance and the sectional elapsed time becomes longer than the corresponding threshold. On the other hand, the controller 30 returns to the process of step S201 when both the sectional travel distance and the sectional elapsed time are respectively shorter than the corresponding thresholds.

In step S205, the controller 30 determines that it is the timing at which the negative electrode reserve capacity is determined when one of the sectional travel distance and the sectional elapsed time becomes longer than the corresponding threshold. In step S205, the controller 30 stores the sectional travel distance and the sectional elapsed time, obtained in the process of step S201, in the memory 31. Here, in order to proceed from the process of step S204 to the process of step S205, one of the sectional travel distance and the sectional elapsed time becomes a value longer than the corresponding threshold, and the other one becomes a value shorter than the corresponding threshold.

Next, the process of step S102 shown in FIG. 2, that is, the process of estimating the negative electrode reserve capacity at present time will be specifically described with reference to the flowchart shown in FIG. 4. The process shown in FIG. 4 is executed by the controller 30.

In step S301, the controller 30 acquires the temperature of the battery pack 10, detected by the temperature sensor 23. The temperature of the battery pack 10 here is the temperature of the battery pack 10 in the past. Specifically, the controller 30 acquires the temperature of the battery pack 10 in a period from when the negative electrode reserve capacity is determined last time to when the negative electrode reserve capacity is determined this time. Here, if the temperature detected by the temperature sensor 23 is stored in the memory 31, it is possible to acquire the temperature of the battery pack 10 in the past.

Here, when the vehicle is traveling, the temperature of the battery pack 10 while the vehicle is traveling is detected by the temperature sensor 23, and the detected temperature is stored in the memory 31. In addition, when the vehicle is left standing, the temperature of the battery pack 10 while the vehicle is left standing is detected by the temperature sensor 23, and the detected temperature is stored in the memory 31. While the vehicle is left standing, the temperature of the battery pack 10 while the vehicle is left standing can be detected by reading the output of the temperature sensor 23 at predetermined intervals.

In step S302, the controller 30 calculates a variation amount in the negative electrode reserve capacity. The negative electrode reserve capacity varies on the basis of the amount of increase in the negative electrode reserve capacity as a result of corrosion of the negative electrode and the amount of reduction in the negative electrode reserve capacity as a result of permeation of hydrogen through the battery case. Therefore, if the amount of increase and the amount of reduction are determined, it is possible to calculate a variation amount in the negative electrode reserve capacity.

It is known that the negative electrode reserve capacity increases as corrosion of the negative electrode advances. In addition, hydrogen present inside the battery case may permeate through the battery case and move to the outside of the battery case. In this case, as hydrogen permeates through the battery case, the negative electrode reserve capacity reduces.

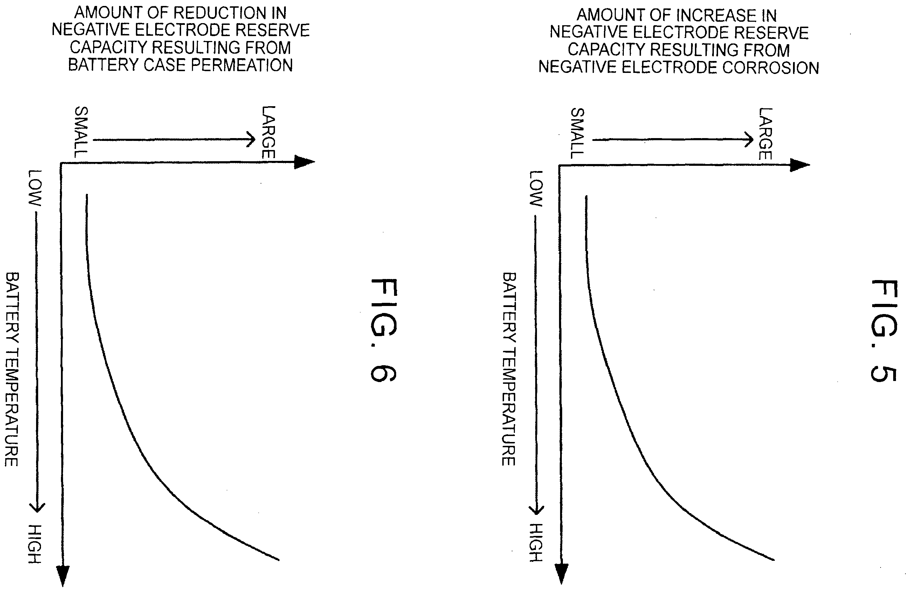

The amount of increase in the negative electrode reserve capacity as a result of corrosion of the negative electrode depends on the temperature of the battery pack 10, and the dependency may be obtained in advance through an experiment, or the like. For example, the amount of increase in the negative electrode reserve capacity and the temperature of the battery pack 10 have the correlation shown in FIG. 5. In FIG. 5, the abscissa axis indicates the temperature of the battery pack 10, and the ordinate axis indicates the amount of increase in the negative electrode reserve capacity as a result of corrosion of the negative electrode.

In the example shown in FIG. 5, as the temperature of the battery pack 10 increases, the amount of increase in the negative electrode reserve capacity increases. In other words, as the temperature of the battery pack 10 decreases, the amount of increase in the negative electrode reserve capacity reduces. The map shown in FIG. 5 is prepared in advance, and information about the map may be stored in the memory 31.

When the map shown in FIG. 5 is used, it is possible to determine the amount of increase in the negative electrode reserve capacity. The amount of increase in the negative electrode reserve capacity corresponds to the temperature of the battery pack 10, acquired in the process of step S301 shown in FIG. 4. Here, when the acquired temperature of the battery pack 10 has varied in the process of step S301, it is possible to, for example, determine a mode value of the temperature distribution and to determine the amount of increase in the negative electrode reserve capacity, corresponding to the mode value.

On the other hand, when the temperature of the battery pack 10 has varied, it is possible to determine the amount of increase in the negative electrode reserve capacity, corresponding to each battery temperature, with the use of the map shown in FIG. 5 in advance, and to assign weights to the amount of increase in the negative electrode reserve capacity on the basis of a duration of each battery temperature. Specifically, as the duration extends, a weighting coefficient that is multiplied by the amount of increase in the negative electrode reserve capacity, corresponding to the battery temperature in that time, is increased. By adding the weighted amount of increase in the negative electrode reserve capacity, it is possible to calculate the amount of increase in the negative electrode reserve capacity.

The amount of reduction in the negative electrode reserve capacity as a result of permeation of hydrogen through the battery case depends on the temperature of the battery pack 10, and the dependency may be obtained in advance through an experiment, or the like. For example, the amount of reduction in the negative electrode reserve capacity and the temperature of the battery pack 10 have the correlation shown in FIG. 6. In FIG. 6, the abscissa axis indicates the temperature of the battery pack 10, and the ordinate axis indicates the amount of reduction in the negative electrode reserve capacity as a result of permeation of hydrogen through the battery case.

In the example shown in FIG. 6, as the temperature of the battery pack 10 increases, the amount of reduction in the negative electrode reserve capacity increases. In other words, as the temperature of the battery pack 10 decreases, the amount of reduction in the negative electrode reserve capacity reduces. The map shown in FIG. 6 is prepared in advance, and information about the map may be stored in the memory 31.

When the map shown in FIG. 6 is used, it is possible to determine the amount of reduction in the negative electrode reserve capacity. The amount of reduction in the negative electrode reserve capacity corresponds to the temperature of the battery pack 10, acquired in the process of step S301 shown in FIG. 4. Here, when the acquired temperature of the battery pack 10 has varied in the process of step S301, it is possible to, for example, determine a mode value of the temperature distribution and to determine the amount of reduction in the negative electrode reserve capacity, corresponding to the mode value.

On the other hand, when the temperature of the battery pack 10 has varied, it is possible to determine the amount of reduction in the negative electrode reserve capacity, corresponding to each battery temperature, with the use of the map shown in FIG. 6 in advance, and to assign weights to the amount of reduction in the negative electrode reserve capacity on the basis of a duration of each battery temperature. Specifically, as the duration extends, a weighting coefficient that is multiplied by the amount of reduction in the negative electrode reserve capacity, corresponding to the battery temperature in that time, is increased. By adding the weighted amount of reduction in the negative electrode reserve capacity, it is possible to calculate the amount of reduction in the negative electrode reserve capacity.

The controller 30 is able to calculate a variation amount in the negative electrode reserve capacity by adding the amount of increase in the negative electrode reserve capacity as a result of corrosion of the negative electrode and the amount of reduction in the negative electrode reserve capacity as a result of permeation of hydrogen through the battery case.

Here, when the amount of increase in the negative electrode reserve capacity as a result of corrosion of the negative electrode is larger than the amount of reduction in the negative electrode reserve capacity as a result of permeation of hydrogen through the battery case, a variation amount in the negative electrode reserve capacity takes a positive value. On the other hand, when the amount of increase in the negative electrode reserve capacity as a result of corrosion of the negative electrode is smaller than the amount of reduction in the negative electrode reserve capacity as a result of permeation of hydrogen through the battery case, a variation amount in the negative electrode reserve capacity takes a negative value. In addition, when the amount of increase in the negative electrode reserve capacity as a result of corrosion of the negative electrode is equal to the amount of reduction in the negative electrode reserve capacity as a result of permeation of hydrogen through the battery case, a variation amount in the negative electrode reserve capacity becomes 0.

In step S303, the controller 30 calculates the current negative electrode reserve capacity in the battery pack 10. Specifically, the controller 30 calculates the current negative electrode reserve capacity by adding the variation amount calculated in the process of step S302 to the negative electrode reserve capacity calculated last time.

Here, if the variation amount in the negative electrode reserve capacity is a positive value, the current negative electrode reserve capacity is larger than the last negative electrode reserve capacity. In addition, if the variation amount in the negative electrode reserve capacity is a negative value, the current negative electrode reserve capacity is smaller than the last negative electrode reserve capacity. Normally, as the vehicle is caused to travel or as the time elapses, degradation of the battery pack 10 advances, and the negative electrode reserve capacity tends to decrease.

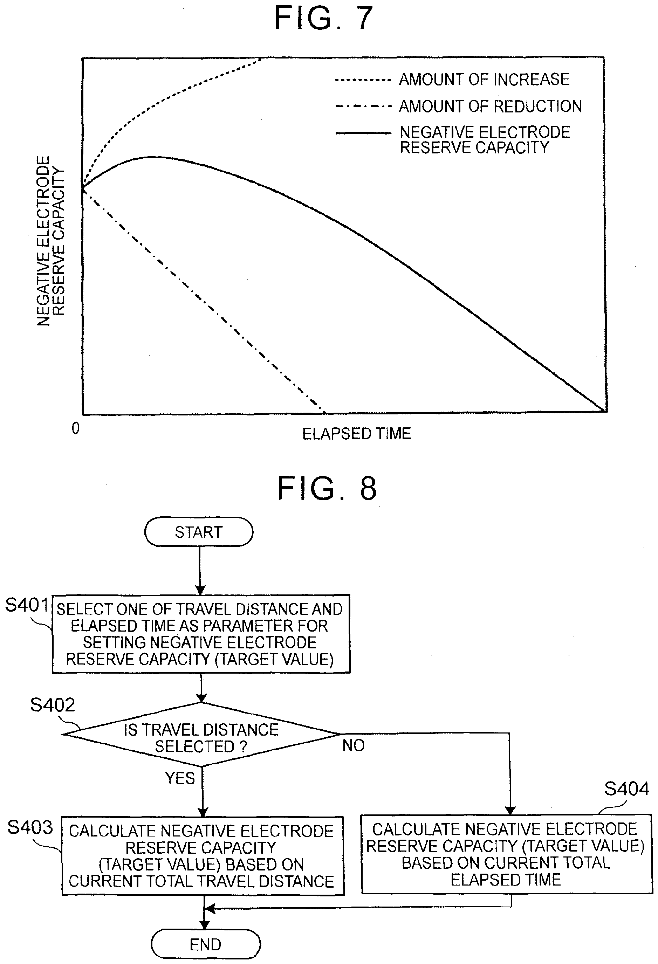

FIG. 7 shows changes (one example) of the negative electrode reserve capacity. In FIG. 7, the ordinate axis represents a negative electrode reserve capacity, and the abscissa axis represents an elapsed time. In addition, the dashed line indicates the amount of increase in the negative electrode reserve capacity as a result of corrosion of the negative electrode, and the alternate long and short dashed line indicates the amount of reduction in the negative electrode reserve capacity as a result of permeation of hydrogen through the battery case. The solid line indicates changes of the negative electrode reserve capacity calculated through the process shown in FIG. 4.

It is possible to calculate the current negative electrode reserve capacity in the battery pack 10 by adding the amount of increase and the amount of reduction to the negative electrode reserve capacity at the time when the battery pack 10 is in an initial state. Here, the initial state is a state at the time when the battery pack 10 starts to be used, and means a state at the time when the elapsed time is 0. As shown in FIG. 7, in a period after the battery pack 10 starts to be used, the negative electrode reserve capacity increases as compared to the negative electrode reserve capacity in the initial state. After the negative electrode reserve capacity has reached a peak value, the negative electrode reserve capacity continues to reduce.

Next, the process of calculating the target value of the negative electrode reserve capacity will be specifically described with reference to the flowchart shown in FIG. 8. The process shown in FIG. 8 is executed by the controller 30. In addition, the process shown in FIG. 8 is started at the time when the ignition switch is switched from the off state to the on state.

In step S401, the controller 30 selects one of the travel distance and the elapsed time as a parameter for setting the target value of the negative electrode reserve capacity. Specifically, in the process of step S204 shown in FIG. 3, when the sectional travel distance has reached the threshold (travel distance) before the sectional elapsed time reaches the threshold (elapsed time), the controller 30 selects the travel distance as a parameter for setting the target value of the negative electrode reserve capacity. On the other hand, when the sectional elapsed time has reached the threshold (elapsed time) before the sectional travel distance reaches the threshold (travel distance), the controller 30 selects the elapsed time as a parameter for setting the target value of the negative electrode reserve capacity.

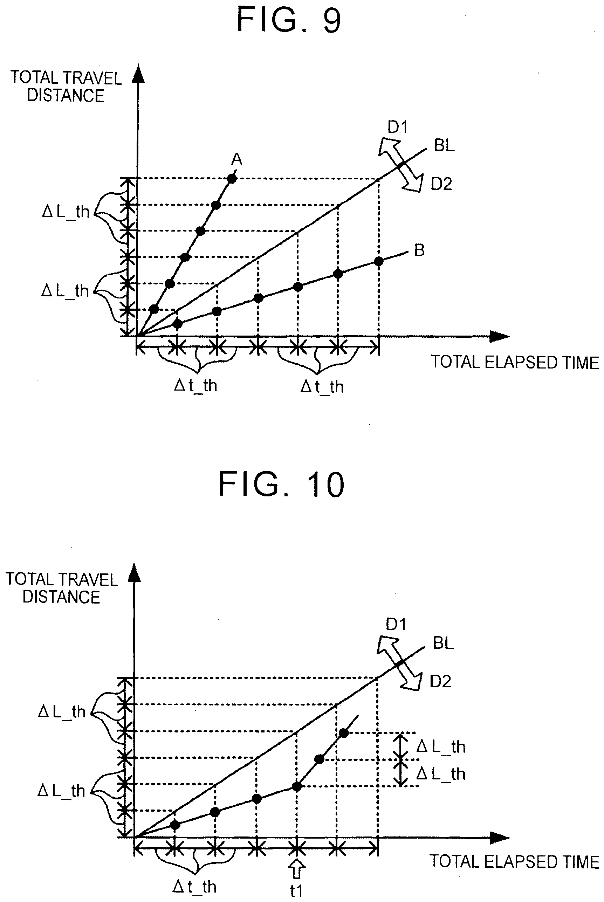

FIG. 9 shows the correlation between a total travel distance and a total elapsed time in mutually different travel patterns (usage states) A, B. In FIG. 9, the ordinate axis represents a total travel distance, and the abscissa axis represents a total elapsed time. The total travel distance is a travel distance in a period from when the vehicle starts to be used to present time. The total elapsed time is an elapsed time in a period from when the vehicle starts to be used to present time.

The black circles in FIG. 9 respectively indicate the timings at which the negative electrode reserve capacity is determined. In the travel pattern A, each time the sectional travel distance reaches the threshold (travel distance) ΔL_th, the negative electrode reserve capacity is determined, so the travel distance is selected as a parameter for setting the target value of the negative electrode reserve capacity.

In the travel pattern B, each time the sectional elapsed time reaches the threshold (elapsed time) Δt_th, the negative electrode reserve capacity is determined, so the elapsed time is selected as a parameter for setting the target value of the negative electrode reserve capacity.

In a region indicated by the arrow D1 with respect to a boundary line BL shown in FIG. 9, before the sectional elapsed time reaches the threshold (elapsed time) Δt_th, the sectional travel distance reaches the threshold (travel distance) ΔL_th. Thus, in the region indicated by the arrow D1 with respect to the boundary line BL, the travel distance is selected as a parameter for setting the target value of the negative electrode reserve capacity.

In a region indicated by the arrow D2 with respect to the boundary line BL, before the sectional travel distance reaches the threshold (travel distance) ΔL_th, the sectional elapsed time reaches the threshold (elapsed time) Δt_th. Thus, in the region indicated by the arrow D2 with respect to the boundary line BL, the elapsed time is selected as a parameter for setting the target value of the negative electrode reserve capacity.

If the user of the vehicle is the same, the travel pattern A or the travel pattern B in FIG. 9 tends to be indicated. On the other hand, when the user is changed while the vehicle is being used, the correlation between a total travel distance and a total elapsed time, for example, indicates a behavior shown in FIG. 10.

In FIG. 10, until time t1, before the sectional travel distance reaches the threshold (travel distance) ΔL_th, the sectional elapsed time reaches the threshold (elapsed time) Δt_th. Therefore, until time t1, the elapsed time is selected as a parameter for setting the target value of the negative electrode reserve capacity. On the other hand, after time t1, before the sectional elapsed time reaches the threshold (elapsed time) Δt_th, the sectional travel distance reaches the threshold (travel distance) ΔL_th. Therefore, after time t1, the travel distance is selected as a parameter for setting the target value of the negative electrode reserve capacity.

In the present embodiment, as described above, in a period from the last determination timing of the negative electrode reserve capacity to the current determination timing of the negative electrode reserve capacity, the travel distance (sectional travel distance) and the elapsed time (sectional elapsed time) are acquired. The parameter for setting the target value of the negative electrode reserve capacity is selected on the basis of one of the acquired sectional travel distance and sectional elapsed time, which has reached the corresponding threshold first. Therefore, even when the travel pattern changes, it is possible to set the target value of the negative electrode reserve capacity corresponding to the change.

In step S402 shown in FIG. 8, the controller 30 determines whether the parameter for setting the target value of the negative electrode reserve capacity is the travel distance. In the process of step S401, when the travel distance is selected as a parameter for setting the target value of the negative electrode reserve capacity, the controller 30 executes the process of step S403. On the other hand, in the process of step S401, when the elapsed time is selected as a parameter for setting the target value of the negative electrode reserve capacity, the controller 30 executes the process of step S404.

In step S403, the controller 30 calculates the target value of the negative electrode reserve capacity on the basis of the total travel distance up to present time. In the process of step S205 shown in FIG. 3, the sectional travel distance is stored in the memory 31 each time the negative electrode reserve capacity is determined, so it is possible to calculate the total travel distance up to present time by accumulating the sectional travel distance for which the negative electrode reserve capacity has been determined.

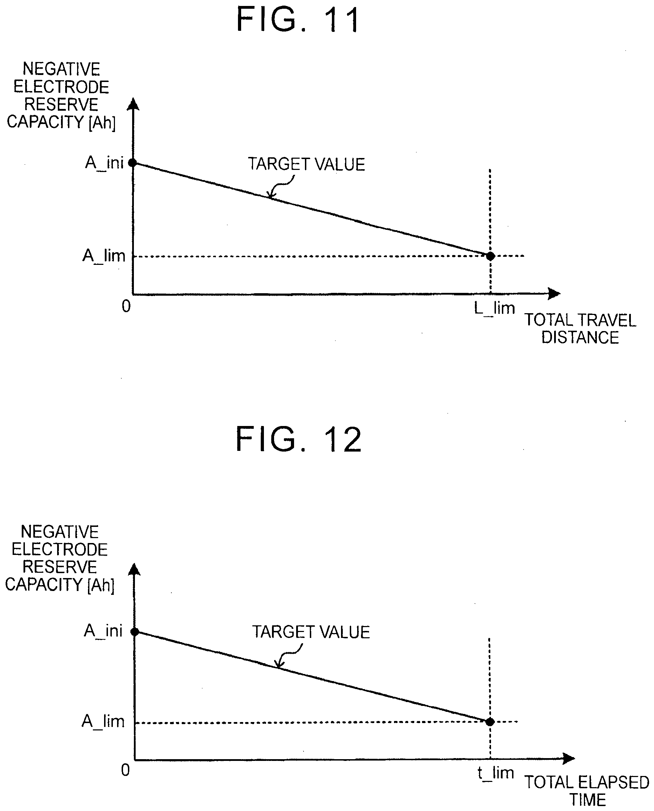

When the target value of the negative electrode reserve capacity is calculated, a map shown in FIG. 11 is initially prepared in advance. In FIG. 11, the abscissa axis represents a total travel distance, and the ordinate axis represents a negative electrode reserve capacity. A_ini indicates a negative electrode reserve capacity at the time when the battery pack 10 is in the initial state, and A_lim indicates a negative electrode reserve capacity (lower limit value) that defines the service life of the battery pack 10. Here, when the negative electrode reserve capacity of the battery pack 10 becomes lower than the negative electrode reserve capacity (lower limit value) A_lim, the battery pack 10 has reached the service life, and the battery pack 10 cannot be continuously used.

When the battery pack 10 is intended to be continuously used until the total travel distance reaches a distance L_lim, the target value of the negative electrode reserve capacity can be, for example, set as shown in FIG. 11. Specifically, a straight line that connects the negative electrode reserve capacity A_ini with the intersection of the total travel distance L_lim and the negative electrode reserve capacity (lower limit value) A_lim can be set as the target value of the negative electrode reserve capacity.

Here, the target value of the negative electrode reserve capacity shown in FIG. 11 is one example, and is not limited to this configuration. That is, the target value of the negative electrode reserve capacity may be set in consideration of the negative electrode reserve capacity A_ini and the intersection of the total travel distance L_lim and the negative electrode reserve capacity (lower limit value) A_lim. Specifically, the target value of the negative electrode reserve capacity may be set such that the negative electrode reserve capacity does not become lower than the negative electrode reserve capacity (lower limit value) A_lim until the total travel distance reaches the distance L_lim.

When the map shown in FIG. 11 is used, it is possible to determine the target value of the negative electrode reserve capacity corresponding to the total travel distance up to present time. Unless the current negative electrode reserve capacity, in other words, the estimated value of the negative electrode reserve capacity calculated in the process of step S102 in FIG. 2, becomes lower than the target value of the negative electrode reserve capacity, it is possible to suppress a decrease in the negative electrode reserve capacity below the negative electrode reserve capacity (lower limit value) A_lim until the total travel distance reaches the distance L_lim. That is, until the total travel distance reaches the distance L_lim, it is possible to continuously use the battery pack 10.

In step S404 shown in FIG. 8, the controller 30 calculates the target value of the negative electrode reserve capacity on the basis of the total elapsed time up to present time. In the process of step S205 shown in FIG. 3, the sectional elapsed time is stored in the memory 31 each time the negative electrode reserve capacity is determined, so it is possible to calculate the total elapsed time up to present time by accumulating the sectional elapsed time for which the negative electrode reserve capacity has been determined.

When the target value of the negative electrode reserve capacity is calculated, a map shown in FIG. 12 is initially prepared in advance. In FIG. 12, the abscissa axis represents a total elapsed time, and the ordinate axis represents a negative electrode reserve capacity. A_ini indicates a negative electrode reserve capacity at the time when the battery pack 10 is in the initial state, and A_lim indicates a negative electrode reserve capacity (lower limit value) that defines the service life of the battery pack 10. The negative electrode reserve capacities A_ini, A_lim shown in FIG. 12 are the same as the negative electrode reserve capacities A_ini, A_lim shown in FIG. 11.

When the battery pack 10 is intended to be continuously used until the total elapsed time reaches a time t_lim, the target value of the negative electrode reserve capacity can be, for example, set as shown in FIG. 12. Specifically, a straight line that connects the negative electrode reserve capacity A_ini with the intersection of the total elapsed time t_lim and the negative electrode reserve capacity (lower limit value) A_lim can be set as the target value of the negative electrode reserve capacity.

Here, the target value of the negative electrode reserve capacity shown in FIG. 12 is one example, and is not limited to this configuration. That is, the target value of the negative electrode reserve capacity may be set in consideration of the negative electrode reserve capacity A_ini and the intersection of the total elapsed time t_lim and the negative electrode reserve capacity (lower limit value) A_lim. Specifically, the target value of the negative electrode reserve capacity may be set such that the negative electrode reserve capacity does not become lower than the negative electrode reserve capacity (lower limit value) A_lim until the total elapsed time reaches the time t_lim.

When the map shown in FIG. 12 is used, it is possible to determine the target value of the negative electrode reserve capacity. The target value of the negative electrode reserve capacity corresponds to the total elapsed time up to present time. Unless the current negative electrode reserve capacity, in other words, the estimated value of the negative electrode reserve capacity calculated in the process of step S102 in FIG. 2, becomes lower than the target value of the negative electrode reserve capacity, it is possible to suppress a decrease in the negative electrode reserve capacity below the negative electrode reserve capacity (lower limit value) A_lim until the total elapsed time reaches the time t_lim. That is, until the total elapsed time reaches the time t_lim, it is possible to continuously use the battery pack 10.

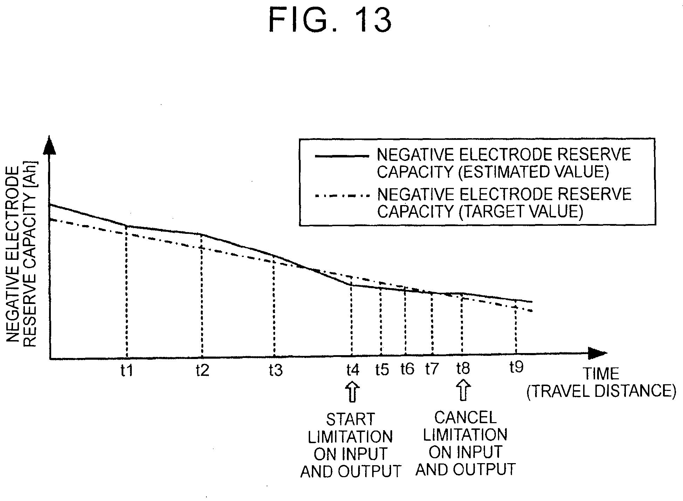

FIG. 13 shows a behavior of the estimated value of the negative electrode reserve capacity at the time when the process shown in FIG. 2 is executed. In FIG. 13, the ordinate axis represents a negative electrode reserve capacity, the abscissa axis represents a time, and the time corresponds to the travel distance. Time t1 to time t9 shown in FIG. 13 indicate the timings at which the process of determining the negative electrode reserve capacity is executed. The solid line shown in FIG. 13 indicates the estimated value of the negative electrode reserve capacity that is calculated in the process of step S102 shown in FIG. 2, and the alternate long and short dashed line shown in FIG. 13 indicates the target value of the negative electrode reserve capacity that is calculated in the process of step S103 shown in FIG. 2.

In FIG. 13, from time t1 to time t3, the estimated value of the negative electrode reserve capacity is larger than the target value of the negative electrode reserve capacity, so the process of limiting the input and output of the battery pack 10 (the process of step S105 shown in FIG. 2) is not executed. On the other hand, when the estimated value of the negative electrode reserve capacity becomes smaller than the target value of the negative electrode reserve capacity at time t4, the process of limiting the input and output of the battery pack 10 (the process of step S105 shown in FIG. 2) is executed.

Here, when the input and output of the battery pack 10 are limited, it is possible to reduce a period during which the process of determining the negative electrode reserve capacity is executed as shown in FIG. 13. Specifically, it is possible to reduce the threshold (travel distance) ΔL_th after the input and output of the battery pack 10 are limited as compared to the threshold (travel distance) ΔL_th before the input and output of the battery pack 10 are limited. In addition, it is possible to reduce the threshold (elapsed time) Δt_th after the input and output of the battery pack 10 are limited as compared to the threshold (elapsed time) Δt_th before the input and output of the battery pack 10 are limited.

In this way, by reducing a period during which the process of determining the negative electrode reserve capacity is executed after the input and output of the battery pack 10 are limited, it becomes easy to acquire the behavior of the estimated value of the negative electrode reserve capacity as a result of limitation on the input and output of the battery pack 10. As shown from time t4 to time t7 in FIG. 13, by limiting the input and output of the battery pack 10, it is possible to bring the estimated value of the negative electrode reserve capacity close to the target value of the negative electrode reserve capacity.

In FIG. 13, at time t8, the estimated value of the negative electrode reserve capacity is larger than the target value of the negative electrode reserve capacity. Thus, the controller 30 cancels the process of limiting the input and output of the battery pack 10 (the process of step S105 shown in FIG .2). When the process of limiting the input and output of the battery pack 10 is cancelled, the period during which the process of determining the negative electrode reserve capacity is executed is returned to an original period. That is, a period from time t8 to time t9 is equal to a period from time t1 to time t2 (t2 to t3, t3 to t4).

According to the present embodiment, when the estimated value of the negative electrode reserve capacity is calculated, not only the temperature of the battery pack 10 at the time when the vehicle is traveling but also the temperature of the battery pack 10 at the time when the vehicle is left standing is taken into consideration. The service life of the battery pack 10 is easily influenced by not only the temperature at the time when the vehicle is traveling but also the temperature at the time when the vehicle is left standing. Therefore, by calculating the estimated value of the negative electrode reserve capacity also in consideration of the temperature of the battery pack 10 at the time when the vehicle is left standing, it is possible to improve the accuracy of the estimated value of the negative electrode reserve capacity.

In the present embodiment, the target value of the negative electrode reserve capacity is set in consideration of the travel distance and the elapsed time. That is, the parameter (travel distance or elapsed time) that defines the service life of the battery pack 10 is selected on the basis of the travel pattern of the vehicle (travel pattern A or travel pattern B shown in FIG. 9), and the service life of the battery pack 10 is executed to a predetermined value (the total travel distance L_lim shown in FIG. 11 or the total elapsed time t_lim shown in FIG. 12) for the selected parameter.

In the present embodiment, the description is made on the case where the single cells 11 are mounted on the vehicle; however, the arrangement of the single cells 11 is not limited to this configuration. That is, as long as a system that controls charging and discharging operations of each single cell 11 on the basis of the negative electrode reserve capacity of the single cell 11, the invention is applicable. Here, the estimated value of the negative electrode reserve capacity of each single cell 11, as in the case of the process shown in FIG. 4, may be calculated on the basis of a temperature at the time when the single cell 11 is being charged or discharged and a temperature at the time when the single cell 11 is not being charged or discharged.

## Claims

1. A battery system for controlling charging and discharging operations of a nickel metal hydride battery (11), the battery system **characterized by** comprising:
a temperature sensor (23) configured to detect a temperature of the nickel metal hydride battery (11); and
a controller (30) configured to
limit the charging and discharging operations of the nickel metal hydride battery (11) when a negative electrode reserve capacity of the nickel metal hydride battery (11) is smaller than a target value,
acquire the temperature of the nickel metal hydride battery (11) at the time when the nickel metal hydride battery (11) is being charged or discharged and the temperature of the nickel metal hydride battery (11) at the time when the nickel metal hydride battery (11) is not being charged or discharged with the use of the temperature sensor (23), and
calculate the negative electrode reserve capacities corresponding to the acquired temperatures using a correspondence relationship between the temperature of the nickel metal hydride battery (11) and the negative electrode reserve capacity.

2. The battery system according to claim 1, **characterized in that**
the controller (30) is configured to calculate the negative electrode reserve capacity by adding an amount of increase in the negative electrode reserve capacity as a result of corrosion of a negative electrode and an amount of reduction in the negative electrode reserve capacity as a result of emission of hydrogen to an outside of the nickel metal hydride battery (11), the amount of increase in the nickel metal hydride battery (11) varying with the temperature of the nickel metal hydride battery (11), the amount of reduction in the nickel metal hydride battery varying with the temperature of the nickel metal hydride battery (11).

3. The battery system according to claim 1 or 2, **characterized in that**
the controller (30) is configured to reduce an interval at which the negative electrode reserve capacity is calculated at the time when the charging and discharging operations of the nickel metal hydride battery (11) are limited as compared to an interval at which the negative electrode reserve capacity is calculated at the time when the charging and discharging operations of the nickel metal hydride battery (11) are not limited.

4. The battery system according to any one of claims 1 to 3, **characterized in that**
the controller (30) is configured to, after the charging and discharging operations of the nickel metal hydride battery (11) are limited, cancel the limitation on the charging and discharging operations when the negative electrode reserve capacity becomes larger than the target value.

5. The battery system according to any one of claims 1 to 4, **characterized in that**
the nickel metal hydride battery (11) is mounted on a vehicle and is configured to output electric energy that is converted to kinetic energy for propelling the vehicle, and
the controller (30) is configured to select one of a travel distance and an elapsed time, which defines a service life of the nickel metal hydride battery (11), on the basis of a usage state of the vehicle, the controller being configured to set the target value such that, when the travel distance is selected, the negative electrode reserve capacity does not reach the negative electrode reserve capacity corresponding to the service life of the nickel metal hydride battery (11) until the travel distance reaches a target travel distance, the controller (30) being configured to set the target value such that, when the elapsed time is selected, the negative electrode reserve capacity does not reach the negative electrode reserve capacity corresponding to the service life of the nickel metal hydride battery (11) until the elapsed time reaches a target elapsed time.

6. The battery system according to claim 5, **characterized in that**
the controller (30) is configured to compare the negative electrode reserve capacity with the target value each time one of the travel distance of the vehicle and the elapsed time reaches a corresponding threshold.

## Patentansprüche

1. Batteriesystem zum Steuern von Lade- und Entladevorgängen einer Nickel-Metallhydrid-Batterie (11), wobei das Batteriesystem **dadurch gekennzeichnet ist, dass** es umfasst:
einen Temperatursensor (23), der dazu ausgebildet ist, eine Temperatur der Nickel-Metallhydrid-Batterie (11) zu detektieren, und
eine Steuerung (30), die dazu ausgebildet ist,
die Lade- und Entladevorgänge der Nickel-Metallhydrid-Batterie (11) zu begrenzen, wenn eine Negativelektrodenreservekapazität der Nickel-Metallhydrid-Batterie (11) kleiner als ein Sollwert ist,
durch Verwendung des Temperatursensors (23) die Temperatur der Nickel-Metallhydrid-Batterie (11) zu der Zeit zu erfassen, wenn die Nickel-Metallhydrid-Batterie (11) geladen oder entladen wird, und die Temperatur der Nickel-Metallhydrid-Batterie (11) zu der Zeit zu erfassen, wenn die Nickel-Metallhydrid-Batterie (11) nicht geladen oder entladen wird, und
die Negativelektrodenreservekapazitäten, die den erfassten Temperaturen entsprechen, durch Verwendung einer Entsprechungsbeziehung zwischen der Temperatur der Nickel-Metallhydrid-Batterie (11) und der Negativelektrodenreservekapazität zu berechnen.

2. Batteriesystem nach Anspruch 1, **dadurch gekennzeichnet, dass**
die Steuerung (30) dazu ausgebildet ist, die Negativelektrodenreservekapazität durch Addieren eines Anstiegsbetrags der Negativelektrodenreservekapazität infolge von Korrosion einer negativen Elektrode und eines Verringerungsbetrags der Negativelektrodenreservekapazität infolge der Emission von Wasserstoff zu einem Äußeren der Nickel-Metallhydrid-Batterie (11) zu berechnen, wobei der Anstiegsbetrag in der Nickelmetallhybridbatterie (11) mit der Temperatur der Nickel-Metallhydrid-Batterie (11) schwankt, wobei der Verringerungsbetrag in der Nickel-Metallhydrid-Batterie mit der Temperatur der Nickel-Metallhydrid-Batterie (11) schwankt.

3. Batteriesystem nach Anspruch 1 oder 2, **dadurch gekennzeichnet, dass**
die Steuerung (30) dazu ausgebildet ist, ein Zeitintervall, in dem die Negativelektrodenreservekapazität zu der Zeit berechnet wird, wenn Lade- und Entladevorgänge der Nickel-Metallhydrid-Batterie (11) begrenzt werden, verglichen mit einem Zeitintervall zu reduzieren, in dem die Negativelektrodenreservekapazität zu der Zeit berechnet wird, wenn die Lade- und Entladevorgänge der Nickel-Metallhydrid-Batterie (11) nicht begrenzt werden.

4. Batteriesystem nach einem beliebigen der Ansprüche 1 bis 3, **dadurch gekennzeichnet, dass**
die Steuerung (30) dazu ausgebildet ist, nachdem die Lade- und Entladevorgänge der Nickel-Metallhydrid-Batterie (11) begrenzt werden, die Begrenzung der Lade- und Entladevorgänge zu beenden, wenn die Negativelektrodenreservekapazität größer als der Sollwert wird.

5. Batteriesystem nach einem beliebigen der Ansprüche 1 bis 4, **dadurch gekennzeichnet, dass**
die Nickel-Metallhydrid-Batterie (11) an einem Fahrzeug angebracht ist und dazu ausgebildet ist, elektrische Energie abzugeben, die in kinetische Energie zum Antreiben des Fahrzeugs umgewandelt wird, und
die Steuerung (30) dazu ausgebildet ist, eine aus der Gruppe umfassend eine gefahrene Wegstrecke und eine verstrichene Zeit, welche eine Lebensdauer der Nickel-Metallhydrid-Batterie (11) definiert, auf der Basis eines Benutzungszustands des Fahrzeugs auszuwählen, wobei die Steuerung dazu ausgebildet ist, den Sollwert derart einzustellen, dass, wenn die gefahrene Wegstrecke ausgewählt wird, die Negativelektrodenreservekapazität die Negativelektrodenreservekapazität, die der Lebensdauer der Nickel-Metallhydrid-Batterie (11) entspricht, erst dann erreicht, wenn die gefahrene Wegstrecke eine gefahrene Sollwegstrecke erreicht, wobei die Steuerung (30) dazu ausgebildet ist, den Sollwert derart einzustellen, dass, wenn die verstrichene Zeit ausgewählt wird, die Negativelektrodenreservekapazität die Negativelektrodenreservekapazität, die der Lebensdauer der Nickel-Metallhydrid-Batterie (11) entspricht, erst dann erreicht, wenn die verstrichene Zeit eine verstrichene Sollzeit erreicht.

6. Batteriesystem nach Anspruch 5, **dadurch gekennzeichnet, dass**
die Steuerung (30) dazu ausgebildet ist, immer dann, wenn eine aus der Gruppe umfassend die gefahrene Wegstrecke des Fahrzeugs und die verstrichene Zeit einen entsprechenden Schwellenwert erreicht, die Negativelektrodenreservekapazität mit dem Sollwert zu vergleichen.

## Revendications

1. Système de batterie destiné à commander des opérations de charge et de décharge d'une batterie nickel-hydrure de métal (11), le système de batterie étant **caractérisé en ce qu'**il comporte :
un capteur de température (23) configuré pour détecter une température de la batterie nickel-hydrure de métal (11) ; et
un circuit de commande (30) configuré pour
limiter les opérations de charge et de décharge de la batterie nickel-hydrure de métal (11) quand une capacité de réserve d'électrode négative de la batterie nickel-hydrure de métal (11) est plus petite qu'une valeur de cible,
acquérir la température de la batterie nickel-hydrure de métal (11) au moment où la batterie nickel-hydrure de métal (11) est chargée ou déchargée et la température de la batterie nickel-hydrure de métal (11) au moment où la batterie nickel-hydrure de métal (11) n'est pas chargée ou déchargée avec l'utilisation du capteur de température (23), et
calculer les capacités de réserve d'électrode négative correspondant aux températures acquises en utilisant une relation de correspondance entre la température de la batterie nickel-hydrure de métal (11) et la capacité de réserve d'électrode négative.

2. Système de batterie selon la revendication 1, **caractérisé en ce que**
le circuit de commande (30) est configuré pour calculer la capacité de réserve d'électrode négative en ajoutant une quantité d'augmentation de la capacité de réserve d'électrode négative comme résultat de la corrosion d'une électrode négative et une quantité de réduction de la capacité de réserve d'électrode négative comme résultat de l'émission d'hydrogène vers l'extérieur de la batterie nickel-hydrure de métal (11), la quantité d'augmentation dans la batterie nickel-hydrure de métal (11) variant avec la température de la batterie nickel-hydrure de métal (11), la quantité de réduction dans la batterie nickel-hydrure de métal variant avec la température de la batterie nickel-hydrure de métal (11).

3. Système de batterie selon la revendication 1 ou 2, **caractérisé en ce que** le circuit de commande (30) est configuré pour réduire un intervalle pour lequel la capacité de réserve d'électrode négative est calculée au moment où les opérations de charge et de décharge de la batterie nickel-hydrure de métal (11) sont limitées comparé à un intervalle pour lequel la capacité de réserve d'électrode négative est calculée au moment où les opérations de charge et de décharge de la batterie nickel-hydrure de métal (11) ne sont pas limitées.

4. Système de batterie selon l'une quelconque des revendications 1 à 3, **caractérisé en ce que**
le circuit de commande (30) est configuré pour, une fois que les opérations de charge et de décharge de la batterie nickel-hydrure de métal (11) sont limitées, annuler la limitation des opérations de charge et de décharge quand la capacité de réserve d'électrode négative devient plus grande que la valeur de cible.

5. Système de batterie selon l'une quelconque des revendications 1 à 4, **caractérisé en ce que**
la batterie nickel-hydrure de métal (11) est montée sur un véhicule et est configurée pour délivrer de l'énergie électrique qui est convertie en énergie cinétique pour propulser le véhicule, et
le circuit de commande (30) est configuré pour sélectionner un d'une distance de déplacement et d'un temps écoulé, qui définit une durée de vie de la batterie nickel-hydrure de métal (11), sur la base d'un état d'utilisation du véhicule, le circuit de commande étant configuré pour établir la valeur de cible de telle sorte que, quand la distance de déplacement est sélectionnée, la capacité de réserve d'électrode négative n'atteint pas la capacité de réserve d'électrode négative correspondant à la durée de vie de la batterie nickel-hydrure de métal (11) jusqu'à ce que la distance de déplacement atteigne une distance de déplacement de cible, le circuit de commande (30) étant configuré pour établir la valeur de cible de telle sorte que, quand le temps écoulé est sélectionné, la capacité de réserve d'électrode négative n'atteint pas la capacité de réserve d'électrode négative correspondant à la durée de vie de la batterie nickel-hydrure de métal (11) jusqu'à ce que le temps écoulé atteigne un temps écoulé de cible.

6. Système de batterie selon la revendication 5, **caractérisé en ce que**
le circuit de commande (30) est configuré pour comparer la capacité de réserve d'électrode négative à la valeur de cible chaque fois que l'un de la distance de déplacement du véhicule et du temps écoulé atteint un seuil correspondant.
